# EUROPEAN PATENT SPECIFICATION

(11) **EP 4 200 917 B1**
(45) Date of publication and mention of the grant of the patent: **19.08.2026**
(21) Application number: 20950544.5
(22) Date of filing: 24.08.2020
(51) Int. Cl.: H10N 30/076, H10N 30/079, H10N 30/00, H10N 30/853

(54) **PIEZOELECTRIC DEVICE STACK AND METHOD OF FORMING THEREOF**
PIEZOELEKTRISCHER BAUGRUPPENSTAPEL UND VERFAHREN ZU SEINER HERSTELLUNG
EMPILEMENT DE DISPOSITIFS PIÉZOÉLECTRIQUES ET PROCÉDÉ POUR SA FABRICATION

(43) Date of publication of application: 28.06.2023
(73) Proprietor: Applied Materials, Inc., Santa Clara, California 95054 (US)
(72) Inventor: SANGLE, Abhijeet Laxman, Mumbai 400 076 (IN); SHARMA, Vijay Bhan, Mumbai 400 076 (IN); XUE, Yuan, Shaanxi 710119 (CN); KADAM, Ankur, Mumbai 400 076 (IN); RAMAKRISHNAN, Bharatwaj, Santa Clara, CA 95054 (US); PAI, Uday, Santa Clara, CA 95054 (US); PATIL, Nilesh, Mumbai 400 076 (IN)
(74) Representative: Zimmermann & Partner Patentanwälte mbB
(86) International application number: PCT/CN2020/110838
(87) International publication number: WO 2022/040869

(56) References cited:
- WO-A1-2015/125520
- WO-A1-2021/096884
- CN-A- 108 183 163
- CN-A- 111 130 490
- JP-A- 2011 238 774
- US-A1- 2008 055 369
- US-A1- 2009 045 704
- US-A1- 2015 231 884
- US-A1- 2016 111 628
- US-A1- 2016 254 439
- GABLECH I ET AL: "Preparation of (001) preferentially oriented titanium thin films by ion-beam sputtering deposition on thermal silicon dioxide", JOURNAL OF MATERIAL SCIENCE, KLUWER ACADEMIC PUBLISHERS, DORDRECHT, vol. 51, no. 7, 21 December 2015 (2015-12-21), pages 3329 - 3336, XP035836227, ISSN: 0022-2461, [retrieved on 20151221], DOI: 10.1007/S10853-015-9648-Y

## Description

### BACKGROUND

### Field

Embodiments of the present disclosure generally relate to piezoelectric devices. More specifically, embodiments disclosed herein relate to piezoelectric devices and methods of depositing films for piezoelectric devices.

### Description of the Related Art

In semiconductor processing, physical vapor deposition (PVD) (e.g., sputtering) is used for transfer of material at the atomic level to deposit thin films or coatings on a substrate. During PVD, a target having a source material is bombarded with ions generated from a plasma within a processing chamber. The bombardment of the target causes the source material to be sputtered (e.g., ejected) from the target towards the substrate being processed. In some examples, the sputtered source material may be accelerated towards the substrate by application of a voltage bias. Upon reaching the surface of the substrate, the source material may react with another material of the substrate to form a thin film or coating thereon.

US 2016/254439 A1 relates to a process for making lead zirconate titanate (PZT) layers. A method includes loading a thermal SiO₂ coated Si wafer in a deposition chamber. The method further includes sputtering of Ti and an oxygen anneal to create TiO₂ rutile as a template for Pt sputter deposition. The method further includes sputtering of Pt. The method further includes creating an oriented rutile TiO₂ seed layer of approximately 5 nm thickness on top of the Pt. The method further includes sputtering a PZT seed layer and sputtering textured PZT. US 2008/055369 A1 relates to a method of manufacturing a piezoelectric element. WO 2021/096884 A1 relates to the fabrication of a piezoelectric device with a lead magnesium niobate-lead titanate piezoelectric layer. US 2016/111628 A1 relates to a method for manufacturing a piezoelectric element.

PVD processes can be utilized to form thin film piezoelectric materials, which are materials that accumulate electric charge upon application of mechanical stress. Piezoelectric materials are frequently used in sensors and transducers for devices such as gyro-sensors, ink-jet printer heads, and other microelectromechanical systems (MEMS) devices, including acoustic resonators for mobile phones and other wireless electronics. Relaxor ferroelectrics, and particularly, relaxor-PT materials, are a type of piezoelectric material exhibiting exceptionally high piezoelectricity due to their unique free energy landscape. In order to realize these exceptional piezoelectric properties, relaxor-PT films must be grown with a uniform perovskite phase structure and <001> crystal orientation (e.g., (001) or (002) orientation). However, growing such relaxor-PT type materials with conventional PVD processes is extremely complex due to the narrow growth window associated with the <001> orientation, as well as the material undergoing various phase transformations with even the slightest change in stoichiometry and/or temperature.

Accordingly, what is needed in the art are improved piezoelectric device stacks and methods of forming piezoelectric device stacks via PVD.

### SUMMARY

The present disclosure generally relates to piezoelectric devices. More specifically, embodiments disclosed herein relate to piezoelectric devices and methods of depositing films for piezoelectric devices.

According to an aspect, a piezoelectric device stack according to independent claim 1 is provided.

According to a further aspect, a method of forming a piezoelectric device stack according to the independent method claim 10 is provided.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, and may admit to other equally effective embodiments.
Figure 1 is a plan view of a cluster tool that is adapted to deposit thin film layers on a substrate by use of one or more processing chambers, according to embodiments described herein.
Figure 2 is a side cross-sectional view of a processing chamber in the cluster tool illustrated in Figure 1 that is adapted to deposit thin film layers on the substrate, according to embodiments described herein
Figure 3A is a side view of an exemplary film stack produced within the cluster tool illustrated in Figure 1, according to examples not covered by the claims.
Figure 3B is a side view of an exemplary film stack produced within the cluster tool illustrated in Figure 1, according to the present invention.
Figure 4 is a flow chart depicting an exemplary method of producing the film stacks illustrated Figures 3A and 3B.
Figure 5 is a plan view of a controller that can provide instructions to the any one of the processing chambers depicted in Figures 1-3, according to embodiments described herein.
Figure 6A is a diagram of x-ray diffraction (XRD) data of piezoelectric films formed by the method depicted in Figure 4, according to embodiments described herein.
Figure 6B is a diagram of x-ray diffraction (XRD) data of piezoelectric films formed by the method depicted in Figure 4, according to embodiments described herein.

To facilitate understanding, identical reference numerals have been used, where possible, to designate identical elements that are common to the Figures. It is contemplated that elements and features of one embodiment may be beneficially incorporated in other embodiments without further recitation.

### DETAILED DESCRIPTION

The present disclosure generally relates to piezoelectric devices. More specifically, embodiments disclosed herein relate to piezoelectric devices and methods of depositing films for piezoelectric devices.

Conventionally, large-scale deposition of thin metal films has been challenging due to non-uniformities of the thin metal films from center to edge thereof. During deposition processes involving sputtering (e.g., physical vapor deposition or "PVD"), differences in the arrangement of atoms in the film layers on the substrate may result in cone defects, stacking defects, and other surface defects being formed in subsequently deposited film layers. For piezoelectric device stacks, such defects may result in weakened piezoelectric coupling and suboptimal piezoelectric properties of the resulting device.

An improvement in deposited thin film properties can be achieved in various types of deposited films, such as piezoelectric materials, through the methods disclosed herein. The methods disclosed herein enable deposition of seed and template film layers having improved thickness and crystal orientation uniformity, which may be studied using X-ray diffraction (XRD) techniques. In certain examples, an ultra-thin seed layer having a uniform thickness from center to edge thereof is deposited on a substrate. A template layer is deposited on a substrate, particularly wherein the template layer closely matches the crystal structure of a subsequently formed piezoelectric material layer. The improved uniformity in orientation and thickness for these layers, in turn, facilitates the growth of piezoelectric materials thereon with improved crystallinity and hence, excellent piezoelectric properties.

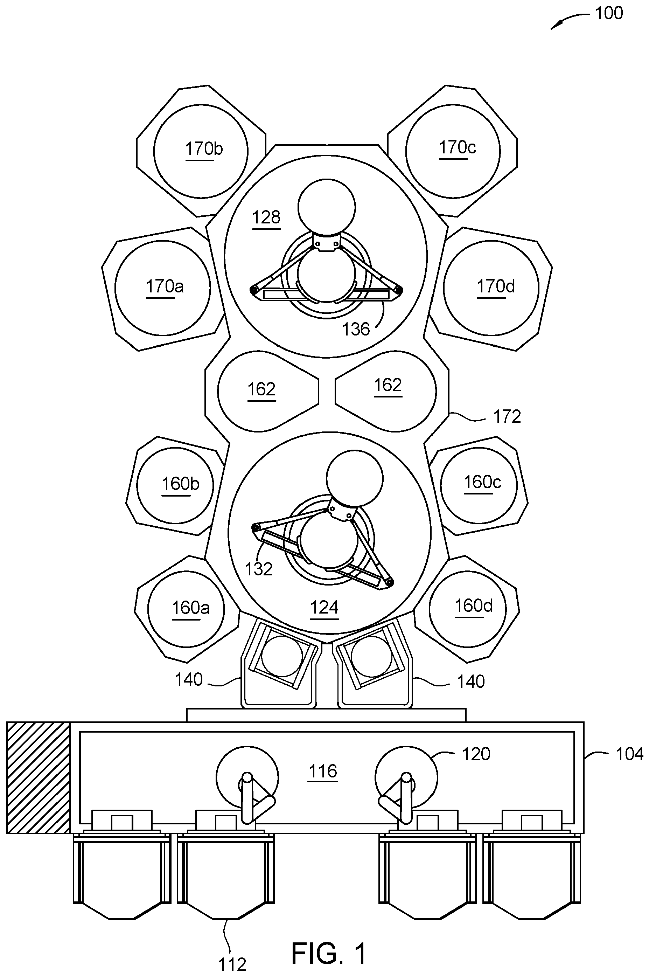

Figure 1 is a schematic plan view of a cluster tool 100. One example of the cluster tool 100 is the Endura^{®} system from Applied Materials, Inc. of Santa Clara, California. It is understood that the cluster tool 100 described below is an exemplary cluster tool and other cluster tools, including those from other manufacturers, may be used with or modified to form piezoelectric device stacks as described herein.

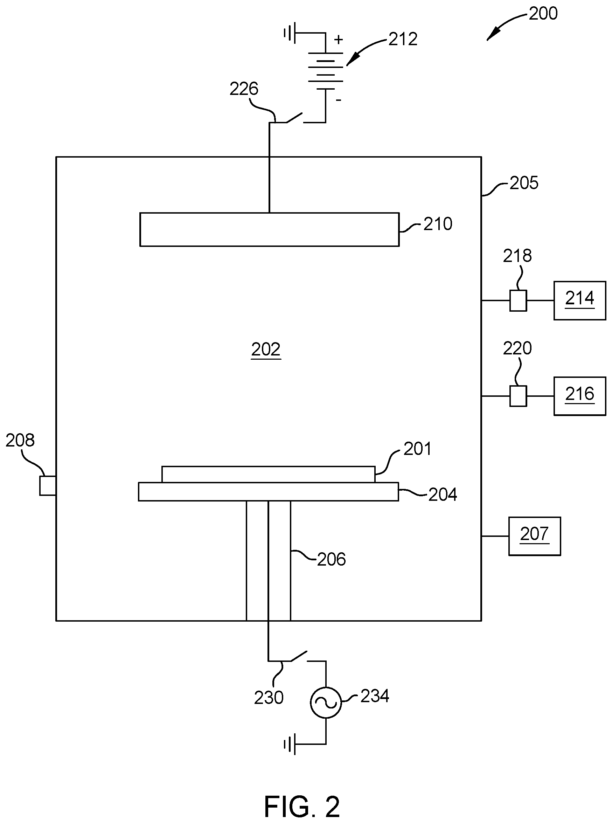

The cluster tool 100 includes a factory interface 104, loading dock 140, first transfer chamber 124, and second transfer chamber 128. A plurality of cassettes 112, or front opening unified pods ("FOUPs"), are disposed on the factory interface 104 and are configured to receive a plurality of substrates (shown in Figure 2 as 201) for processing. The substrates 201 may have a diameter in a range from about 100 mm to about 750 mm and may be formed from a variety of materials, including silicon (Si), silicon carbide (SiC) or SiC-coated graphite. In one example, the substrates 201 include a Si material and have a surface area of about 1,000 cm² or more. In another example, the surface area of the substrates 201 may be about 2,000 cm² or more, and about 4,000 cm² or more. Prior to processing, the substrates 201 are removed from the cassettes 112 by factory interface robots 120 and are transferred to the loading dock 140 (i.e., load lock). Upon completion of substrate processing in the cluster tool 100, the processed substrates 201 may be returned to their respective cassettes 112.

The first transfer chamber 124 is part of a main frame 172 and houses a centrally disposed first transfer robot 132. The first transfer robot 132 is configured to move the substrates 201 between the loading dock 140 and a plurality of first processing chambers 160 (160a-d are shown in Figure 1) and/or pass-through chambers 162. The first transfer chamber 124 can be selectively isolated from each of the first processing chambers 160 and pass-through chambers 162 by use of slit valves (not shown) that are disposed between each first processing chamber 160 and pass-through chamber 162 and the first transfer chamber 124.

Each loading dock 140 is selectively isolated from the first transfer chamber 124 by slit valves and from the interior region 116 of the factory interface 104 by vacuum doors (not shown). In this configuration, the factory interface robots 120 in the factory interface 104 are configured to move a substrate 201 from a cassette 112 to the loading dock 140, which may be sealed and pumped down to a desired pressure for transfer of the substrates 201 to the first transfer chamber 124. Upon reaching a desired pressure, the substrate 201 can then be accessed by the first transfer robot 132 through a slit valve opening (not shown) formed between the first transfer chamber 124 and the loading dock 140.

The first processing chambers 160 may include any suitable type of processing chambers for forming thin layer film stacks on the substrates 201. In certain embodiments, one or more of the first processing chambers 160 include orient chambers disposed proximate the loading dock 140 and used to align the substrates 201 in a desired rotational orientation within the cluster tool 100. In some embodiments, the orient chambers may include a heat source, such as lamps or infrared generating radiant heaters, adapted to heat the substrate 201 to a desired temperature. The orient chambers can further be pressurized under a vacuum condition to ensure that any undesirable water or other contamination is removed from the surface of the substrates 201 prior to processing in other downstream chambers.

In some embodiments, the first processing chambers 160 further include one or more pre-clean chambers that are adapted to clean the surfaces of the substrates 201. The pre-clean chambers may clean the surfaces of the substrates 201 by use of a cleaning process that includes exposing the surfaces of the substrates 201 to a radio frequency (RF) generated plasma and/or one or more pre-cleaning gas compositions that includes a carrier gas (e.g., Ar, He, Kr) and/or a reactive gas (e.g., hydrogen). In some embodiments, the pre-clean chambers are adapted to perform a process that may include a non-selective sputter etching process.

In certain embodiments, one or more of the first processing chambers 160 are configured to process substrates 201 therein by cooling the substrates 201, heating the substrates 201, etching the substrates 201, and/or depositing one or more layers on surfaces of the substrates 201. In certain embodiments, the deposition processes may include a sputter deposition process (i.e., PVD deposition process). In certain configurations, one or more of the processing chambers 160 are further configured to anneal the substrates 201.

The first transfer chamber 124 and the second transfer chamber 128 are coupled to each other via the pass-through chambers 162. In some configurations, the first transfer chamber 124 may be vacuum pumped to a moderately low pressure, for example, less than about 1 milliTorr (mTorr). The second transfer chamber 128 may be pumped to a lower pressure, for example, 1 microTorr or less. Accordingly, the first and second transfer chambers 124, 128 are maintained at least at a moderate vacuum level to prevent the transfer of contamination between the transfer chambers 124, 128 and other modules of the cluster tool 100.

Similar to the first transfer chamber 124, the second transfer chamber 128 is part of the main frame 172 and houses a centrally disposed second transfer robot 136. The second transfer robot 136 is configured to move the substrates 201 between each of a plurality of second processing chambers 170 and/or the pass-through chambers 162. The second transfer chamber 128 can be selectively isolated from each of the second processing chambers 170 and the pass-through chambers 162 by use of slit valves (not shown) that are disposed between each second processing chamber 170 and pass-through chamber 162 and the second transfer chamber 128.

In certain embodiments, one or more of the second processing chambers 170 are configured to process substrates 201 therein by cooling the substrates 201, heating the substrates 201, etching the substrates 201, and/or depositing one or more layers on surfaces of the substrates 201. In certain embodiments, the deposition processes may include a sputter deposition process (i.e., PVD deposition process). In certain configurations, one or more of the second processing chambers 170 are further configured to anneal the substrates 201.

Figure 2 is a plan view of a processing chamber 200 that can be utilized as a first and/or second processing chamber 160, 170. The processing chamber 200 is a PVD chamber adapted to deposit thin film layers on the substrate 201 in the cluster tool illustrated in Figure 1. It is to be understood that the processing chamber 200 described herein is an exemplary chamber and other PVD chambers, including PVD chambers from other manufacturers, may be used with or modified to accomplish aspects of the present disclosure.

As shown in Figure 2, the processing chamber 200 includes a process volume 202 defined by a chamber body 205. The process volume 202 has a target 210 and pedestal 204 operable to support the substrate 201. The pedestal 204 is coupled to and movably disposed in the process volume 202 by a stem 206 connected to a lift system (not shown) that moves the pedestal 204 between an elevated processing position and a lowered position that facilitates transfer of the substrate 201 to and from the processing chamber 200 through an opening 208 in the chamber body 205.

The target 210 is connected to a power supply 212, such as a DC power supply, a RF power supply, an AC power supply, a pulsed DC power supply, or a pulsed RF power supply, via a target switch 226. During deposition processes, the target 210 may be negatively biased via the pulsed DC power supply providing a pulsed DC power. A sputter gas flow controller 218, such as a mass flow control (MFC) device, is disposed between a sputter gas source 214 and the process volume 202 to control a flow of the sputter gas from the sputter gas source 214 to the process volume 202. A reactive gas flow controller 220, such as an MFC device, is disposed between a reactive gas source 216 and the process volume 202 to control a flow of the reactive gas from the reactive gas source 216 to the process volume 202.

The pedestal 204 is connected to a pedestal switch 230 that when engaged connects the pedestal 204 to a power supply 234, such as a DC power supply, a RF power supply, an AC power supply, a pulsed DC power supply, and a pulsed RF power supply. During deposition processes, the pedestal 204 may be negatively biased via the power supply 234 providing a RF power. In certain embodiments, the processing chamber 200 is operable to independently bias the target 210 and the pedestal 204. A controller 207 is coupled to the processing chamber 200 and is configured to control aspects of the processing chamber 200, for example connecting the target switch 226 and connecting the pedestal switch 230, during processing.

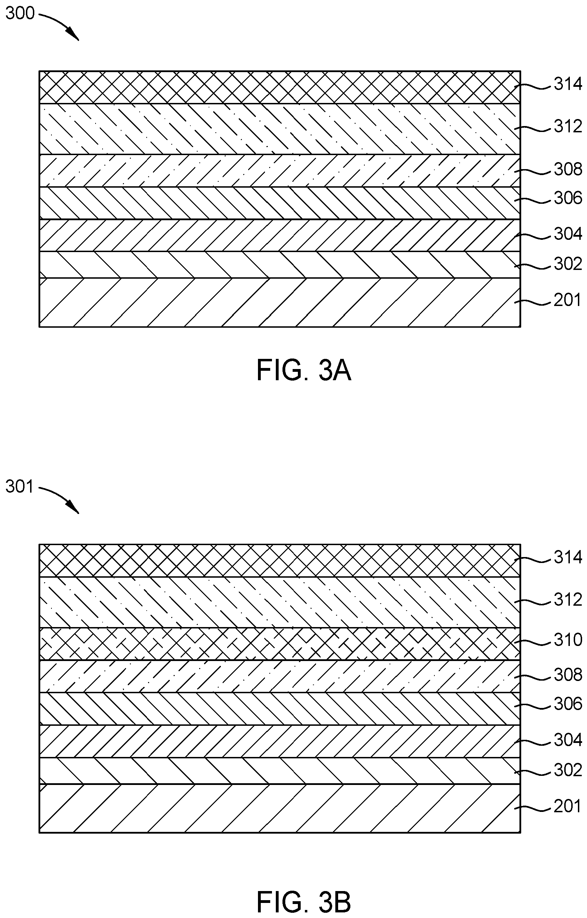

Figure 3A is a side view of an exemplary film stack 300, which is not covered by the claims and produced within the cluster tool disclosed in Figure 1. The film stack 300 includes the substrate 201, a first seed layer 304, a bottom electrode layer 306, a second seed layer 308, a piezoelectric material layer 312, and a top electrode layer 314. Generally, the layers of the film stack 300 are highly uniform in thickness. For example, a thickness of each layer has a delta (e.g., thickness nonuniformity) of about +/- 10% across a lateral length of the layer, such as a delta of about +/- 5%.

The substrate 201, in some examples, is a 200mm silicon (Si) substrate having a crystal orientation of <001> (e.g., (001) or (002)). The substrate 201 may be formed from other metals having an appropriate lattice structure, including but not limited to a polycrystalline molybdenum (Mo), strontium ruthenium oxide (SrRuO3, SRO), lanthanum nickel oxide (LaNiO3, LNO), lanthanum strontium manganite (LaSrMnO3, LSMO), and calcium ruthenate (CaRuO3). In certain embodiments, a thermal oxide layer 302 is grown on a surface of the substrate 201, such as a Si or silicon oxide (SiOx) layer. For example, the thermal oxide layer 302 may be formed of silicon dioxide (SiO₂). The thermal oxide layer 302 may have a thickness between about 10 nm and about 1000 nm, such as between about 15 nm and about 750 nm, for example, between about 20 nm and about 500 nm. In certain embodiments, the thermal oxide layer 302 has a thickness between about 25 nm and about 200 nm, such between about 50 nm and about 150 nm. For example, the thermal oxide layer 302 may have a thickness of between about 75 nm and about 125 nm, such as about 100 nm.

The first seed layer 304 may be formed directly on the surface of the substrate 201 or on a surface of the thermal oxide layer 302. The first seed layer 304 supports growth of the bottom electrode layer 306, which is deposited on a surface of the first seed layer 304 and may act as a bottom electrode for devices. Examples of suitable materials for the bottom electrode layer 306 include platinum (Pt), SrRuO3, LaNiO3, CaRuO3, LaSrMnO3, and the like. In certain examples, the first seed layer 304 is formed of a titanium oxide (TiOx) having an orientation of <001> (e.g., (001) or (002)), such as titanium dioxide (TiO₂), and the bottom electrode layer 306 is formed of Pt having an orientation of <111>. A highly oriented Pt <111> layer is essential for forming a uniform second seed layer 308, which in turn supports formation of the piezoelectric material layer 312 with high orientation control. Accordingly, forming the first seed layer 304 of TiO₂ may support the growth of a Pt bottom electrode layer 306 with exclusively <111> orientation.

Please note that the orientation of the bottom electrode layer 306, as well as seed layers 304, 308, can be detected and confirmed by X-ray diffraction (XRD) analysis, such as 2theta-omega scans, as well as cross-sectional high-resolution transmission electron microscopy (HRTEM). The inventors of the present disclosure have found that by utilizing the methods described herein, only peaks corresponding to the <111> orientation for the bottom electrode layer 306 can be detected with 2theta-omega scanning, and these peaks exhibit high intensities over 10,000 counts per second (cps). The results indicate that the bottom electrode layer 306, as well as the first seed layer 304, are highly oriented.

In certain embodiments, the first seed layer 304 has a thickness between about 10 nm and about 50 nm, such as between about 20 nm and about 30 nm, such as about 25 nm. In certain embodiments, the bottom electrode layer 306 has a thickness between about 50 nm and about 200 nm, such as between about 75 nm and about 175 nm, such as between about 100 nm and about 150 nm, for example, about 125 nm.

The second seed layer 308 is deposited upon the bottom electrode layer 306. The second seed layer 308 includes titanium dioxide having an orientation of <001>. In certain embodiments, the second seed layer 308 is formed of the same or different material than the first seed layer 304. The second seed layer 308 has a uniform thickness between 0.5 nm and 5 nm, such as between about 1 nm and about 3 nm, which is confirmed by cross-sectional HRTEM. For example, the second seed layer 308 has a uniform thickness between about 1.5 nm and about 2.5 nm, such as about 2 nm. As described above, a thin and highly uniform seed layer enables uniformity in subsequent device layers and allows improved process integration.

The piezoelectric material layer 312 is deposited over the second seed layer 308 and is formed of any suitable piezoelectric materials. In certain embodiments, the piezoelectric material layer 312 is formed of one or more layers containing scandium-doped aluminum nitride (ScAlN) or AIN. In certain embodiments, the piezoelectric material layer 312 is formed of one or more layers containing any one of or a combination of titanium nitride (TiN), hafnium nitride (HfN), or silicon nitride (SiₓN_{y}). In some examples, the piezoelectric material layer 312 is formed of a relaxor-lead titanate (PT) type material, such as lead magnesium niobate-lead titanate (PMN-PT) and lead indium niobate-lead magnesium niobate-lead titanate (PIN-PMN-PT). The piezoelectric material layer 312 may have a thickness between about 500 nm and about 2000 nm, such as between about 750 nm and about 1500 nm, such as about 1000 nm.

The top electrode layer 314 is deposited upon the piezoelectric material layer 312 and may act as a top electrode for finished devices. In certain examples, the top electrode layer 314 is formed of the same or different material than the bottom electrode layer 306. For example, the top electrode layer 314 may be formed of Pt having an orientation of <111>. In certain examples, the thickness of the top electrode layer 314 is between about 30 nm and about 200 nm, such as between about 50 nm and about 150, for example, about 100 nm.

Figure 3B is a side view of another exemplary film stack 301, which is part of the present invention and produced within the cluster tool disclosed in Figure 1. As described with reference to film stack 300, the layers of the film stack 301 are highly uniform in thickness. For example, a thickness of each layer has a delta (e.g., variance) of about +/- 10% across a lateral length of the layer, such as a delta of about +/- 5%. The film stack 301 includes the layers described above with reference to Figure 3A, and further includes a template layer 310. The template layer 310 may be deposited directly onto a surface of the bottom electrode layer 306 or the second seed layer 308, and below the piezoelectric material layer 312.

Formation of the template layer 310 is beneficial when the piezoelectric material layer 312 is formed of relaxor-PT type piezoelectric materials, which are a class of complex oxide materials showing exceptionally high piezoelectricity due to a unique free energy landscape. These piezoelectric properties are enhanced when the relaxor-PT type material is formed with a <001> orientation. Thus, in examples where the piezoelectric material layer 312 is formed of relaxor-PT type piezoelectric materials, such as PMN-PT, the template layer 310 may be formed of a perovskite PZT film having an orientation of <001>. PZT has a crystal structure closely matching that of relaxor-PT type piezoelectric materials and thus, a PZT template layer 310 may lower the nucleation energy for growth of a relaxor-PT type piezoelectric material layer 312 with a <001> orientation thereon, resulting in heteroepitaxial, cube-on-cube type crystal growth. This type of growth provides improved crystallinity with a five-fold (e.g., 5x) increase in <001> peak intensity when analyzed by XRD, such as 2theta-omega scans. A greater XRD intensity is crucial for obtaining vastly improved piezoelectric properties. Moreover, as PZT itself is a piezoelectric material, increasing the thickness of the PZT template layer 310 will not adversely affect the electromechanical properties or response of the relaxor-PT type piezoelectric material layer 312. In some examples, the template layer 310 has a thickness between about 10 nm and about 200 nm, such as between about 25 nm and about 175 nm, between about 50 nm and about 150, between about 75 nm and about 125, such as about 100 nm.

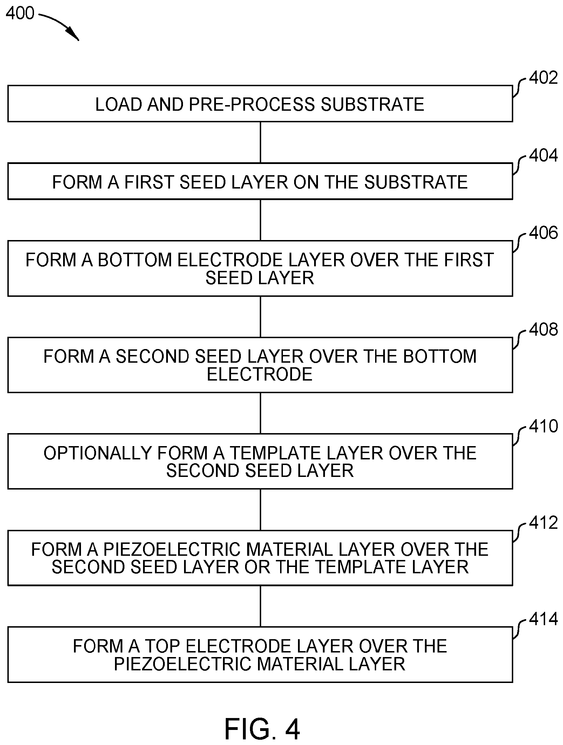

Figure 4 is a flow chart depicting a method 400 of producing the film stacks 300 and 301. To facilitate explanation, Figure 4 will be described with reference to the cluster tool 100 of Figure 1. However, it is to be noted that a cluster tool other than cluster tool 100 of Figure 1 may be utilized in conjunction with method 400.

At block 402, the substrate 201 is loaded into the cluster tool 100 and is pre-processed. The substrate 201 may or may not have a thermal oxide layer, such as thermal oxide layer 302, already formed thereon prior to loading into the cluster tool 100. In certain embodiments, the substrate is loaded into the loading dock 140 by one of the factory interface robots 120 and is then passed through the first transfer chamber 124 by the first transfer robot 132 to an orient chamber, a pre-clean chamber, and/or other first processing chamber 160. As described above, pressure (P) in the first transfer chamber 124 may be about 1 microTorr. Accordingly, the pressure of the cluster tool 100 is held in a vacuum state.

During pre-processing, the substrate 201 may be exposed to a degas process performed in one of the first processing chambers 160. Optionally, a surface of the substrate 201 is exposed to a plasma to pre-clean the surface of the substrate 201, which may occur before or after performing the degas process. For example, the surface of the substrate 201 can be precleaned (e.g., bombarded with reactive gas (e.g., H₂) or non-reactive gas (e.g., Ar, Ne, He) ions and/or gas radicals (e.g., etched)) in a pre-clean chamber prior to being transferred to another first or second processing chamber 160, 170 for deposition of the first seed layer 304. Pre-cleaning the surface of the substrate 201 prior to depositing the first seed layer 304 can reduce surface defects in the first seed layer 304 when the first seed layer 304 is deposited on the substrate 201. Other processes that may be performed during block 402 can also include heating, maintaining the incoming temperature of the substrate 201, or cooling the substrate 201. After pre-processing at block 402, the substrate 201 may be transferred to one or more processing chambers 160, 170, which may include the components shown in processing chamber 200, to form individual layers of the film stacks 300 or 301 thereon.

The first seed layer 304 is formed on the substrate 201 at block 404. In certain embodiments, the first seed layer 304 is formed on the substrate 201 by PVD and/or an anneal and oxidation process. For example, a thin and crystalline Ti film may be deposited by PVD at room temperature, followed by exposure of the Ti film to an anneal and oxidation process to form a TiO₂ layer.

At block 406, the bottom electrode layer 306 is formed over the first seed layer 304 in one of the processing chambers 160, 170. For example, the bottom electrode layer 306 may be deposited on the first seed layer 304 via a PVD process performed in a PVD chamber, such as processing chamber 200. In certain embodiments, the PVD process is performed between about 37 °C and about 600 °C, such as between about 400 °C and about 600 °C, and such as about 500 °C. In certain embodiments, the target in the PVD chamber is negatively biased during the PVD process by a pulsed or continuous power supply providing a DC power with a power level between about 400 W and about 1000 W, such as between about 600 W and about 800 W. In certain embodiments, which can be combined with other embodiments described herein, the flow rate of Ar during the PVD process is between about 20 sccm and about 60 sccm, such as between about 30 sccm and about 50 sccm, and the pressure within the PVD chamber is between about 4 mTorr and about 25 mTorr, such as between about 10 mTorr and about 20 mTorr.

As described above, in certain embodiments, the bottom electrode layer 306 is formed of Pt having an orientation of <111>, thus supporting the subsequent formation of a highly oriented piezoelectric material layer 312. In further embodiments, the Pt bottom electrode layer 306 is deposited on a TiO₂ first seed layer 304.

At block 408, the second seed layer 308 is formed on the bottom electrode layer 306. Similar to the first seed layer 304, the second seed layer 308 is formed by depositing a thin Ti layer via PVD, for instance at room temperature, and then annealing the Ti layer to form a TiO₂ layer. The second seed layer 308 has a uniform thickness between 0.5 nm and 5 nm, such as between about 1 nm and about 3 nm, such as about 2 nm, and a uniform <001> orientation. A thin and highly uniform seed layer with conformal crystal orientation enables uniformity in subsequent device layers and facilitates formation of piezoelectric material layers with excellent piezoelectric properties.

The template layer 310 is formed over the second seed layer 308. In particular, the template layer is then deposited on the second seed layer 308 at block 410, as depicted in film stack 301. The template layer, which may be formed of a perovskite PZT film having an orientation of <001>, is deposited via a PVD process at a temperature between about 500 °C and about 750 °C, such as about 650 °C, and a pressure between about 5 mTorr and about 25 mTorr, such as between about 18 mTorr and about 20 mTorr. In certain embodiments, the target in the PVD chamber is negatively biased during the PVD process by a pulsed or continuous power supply providing a RF power with a power level between about 1000 W and about 2500 W, such as between about 1200 W and about 2000 W. In certain embodiments, which can be combined with other embodiments described herein, the flow rate of Ar during the PVD process is between about 20 sccm and about 60 sccm, such as between about 30 sccm and about 50 sccm, and the flow rate of O₂ is between about 0 sccm and about 20 sccm, such as between about 5 sccm and about 15 sccm.

The deposition process described above results in the template layer 310 having a uniform thickness ranging between about 10 nm and about 200 nm, such as between about 50 nm and about 150 nm, and such as about 100 nm. As previously described, the template layer 310 may be formed of piezoelectric materials having similar properties to the piezoelectric material layer 312, and thus, forming a thicker template layer 310 will not adversely affect the piezoelectric properties of the film stack.

At block 412, the piezoelectric material layer 312 is formed by a PVD process, for instance substantially similar to the process for forming the template layer 310.
In certain embodiments, the target in the PVD chamber is negatively biased by a pulsed or continuous power supply providing a RF power with a power level between about 1000 W and about 2500 W, such as between about 1200 W and about 2000 W. In certain embodiments, which can be combined with other embodiments described herein, the flow rate of Ar during the PVD process is between about 20 sccm and about 60 sccm, such as between about 30 sccm and about 50 sccm, and the flow rate of O₂ is between about 0 sccm and about 20 sccm, and such as between about 5 sccm and about 15 sccm.

In certain examples not covered by the claims, the piezoelectric material layer 312 is formed directly on the second seed layer 308, which is depicted in film stack 300. In embodiments, the piezoelectric material layer 312 is deposited over the template layer 310, particularly as depicted in film stack 301. Formation of the piezoelectric material layer 312 over the template layer 310 is particularly beneficial when the piezoelectric material layer 312 is formed of a relaxor-PT type material, such as lead PMN-PT or PIN-PMN-PT. In such examples, the template layer 310 may be formed with a crystal structure closely matching that of the relaxor-PT type material, thus facilitating uniform heteroepitaxial growth of the piezoelectric material layer 312 with a <001> orientation and excellent piezoelectric properties.

Following the formation of the piezoelectric material layer 312, the top electrode layer 314 is formed over the film stack 300 or 301 at block 414. Similar to the bottom electrode layer 306, the top electrode layer 314 may be formed of Pt deposited over the piezoelectric material layer 312 via a PVD process performed at a temperature between about 300 °C and about 600 °C, such as about 500 °C. In certain embodiments, the target in the PVD chamber is negatively biased during the PVD process by a pulsed or continuous power supply providing a DC power with a power level between about 400 W and about 1000 W, and such as between about 600 W and about 800 W. In certain embodiments, which can be combined with other embodiments described herein, the flow rate of Ar during the PVD process is between about 20 sccm and about 60 sccm, such as between about 30 sccm and about 50 sccm, and the pressure within the PVD chamber is between about 4 mTorr and about 25 mTorr, such as between about 10mTorr and about 20 mTorr.

After blocks 402-414 have been completed, and the film stack 300 or 301 is formed, the substrate 201 may be returned to the factory interface 104 via the first and/or second transfer robots 132, 136 and one of the factory interface robots 120.

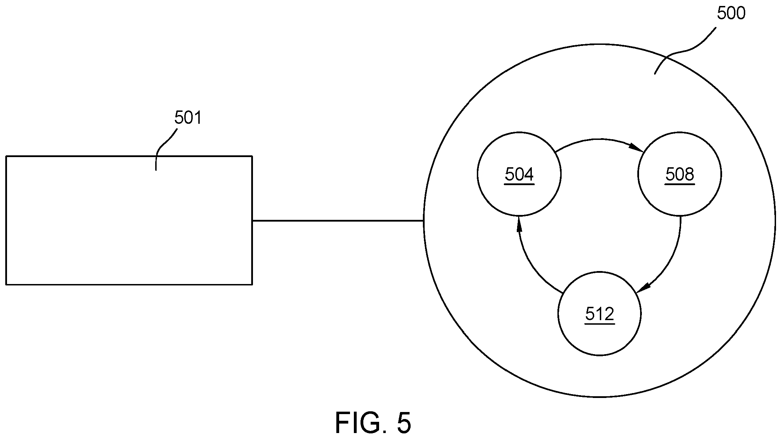

Figure 5 is a schematic plan view of a controller 500 that can provide instructions to any one of the processing chambers depicted in Figures 1-2 during performance of the method 400.

An optional display unit 501 may be coupled to the controller 500. The controller 500 includes a processor 504, a memory 508, and support circuits 512 that are coupled to one another. The controller 500 may be on-board the cluster tool 100, or in an alternative example, the controller 500 may be on-board the processing chamber in Figure 2 or a remote device (not shown).

The display unit 501 includes an input control unit, such as power supplies, clocks, cache, input/output (I/O) circuits, coupled to the various components of the display unit 501 to facilitate control thereof. The processor 504 may be one of any form of general purpose microprocessor, or a general purpose central processing unit (CPU), each of which can be used in an industrial setting, such as a programmable logic controller (PLC).

The memory 508 includes at least one non-transitory computer readable medium and may be one or more of readily available memory such as random access memory (RAM), read only memory (ROM), or any other form of digital storage, local or remote. The memory 508 contains instructions, that when executed by the processor 504 (e.g., central processing unit (CPU), a digital signal processor (DSP), an application-specific integrated circuit (ASIC)), facilitates the operation and processing within of any of the processing chambers illustrated in Figures 1-2. The instructions in the memory 508 are in the form of a program product such as a program that implements the method of the present disclosure. The program code of the program product may conform to any one of a number of different programming languages. Illustrative computer-readable storage media include, but are not limited to: (i) non-writable storage media (e.g., read-only memory devices within a computer such as CD-ROM disks readable by a CD-ROM drive, flash memory, ROM chips, or any type of solid-state non-volatile semiconductor memory) on which information is permanently stored; and (ii) writable storage media (e.g., floppy disks within a diskette drive or hard-disk drive or any type of solid-state random-access semiconductor memory) on which alterable information is stored. Such computer-readable storage media, when carrying computer-readable instructions that direct the functions of the methods described herein, are examples of the present disclosure. The program code within memory 508 can be executed by processor 504 in order to perform various processing methods within an apparatus, such as perform one or more of the method steps described in relation to Figure 4 to produce a film stack 300 or 301 using the various process chambers and supporting components found in the cluster tool 100 illustrated in Figure 1.

In one example, the controller 500 may be implemented as the program product stored on a computer-readable storage media (e.g. 508) for use with a computer system (not shown). The program(s) of the program product define functions of the disclosure, described herein.

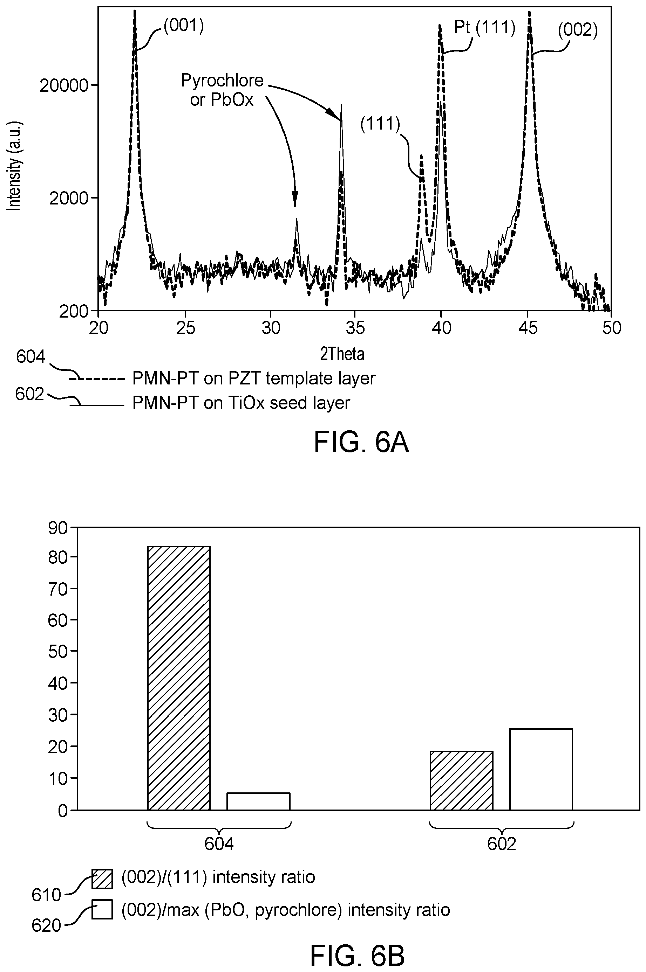

Figure 6A illustrates a comparison of x-ray diffraction (XRD) readings of a PMN-PT piezoelectric material layer 602 formed on a TiOx seed layer and a PMN-PT piezoelectric material layer 604 formed on a PZT template layer, wherein only the latter example is covered by the claims. The piezoelectric material layers 602, 604 are examples of the piezoelectric material layer 312 described above. A vertical axis of Figure 6A represents relative intensity based on arbitrary units (a.u.), and a horizontal axis represents a 2theta scale in degrees (°). Both XRD readings show strong (001) and (002) peaks, indicating piezoelectric material layers with highly uniform <001> crystal orientations. Furthermore, pyrochlore, lead oxide (PbO), and (111) are suppressed to varying degrees for each of the piezoelectric material layers 602, 604. Pyrochlore and Pbo are parasitic phases which degrade piezoelectric performance and therefore, suppression thereof is desired.

Figure 6B illustrates the XRD intensity values in Figure 6A as ratios of desired to undesired peaks. In particular, bars 610 represent a ratio of (002) peak intensity to (111) peak intensity, and bars 620 represent a ratio of (002) peak intensity to a maximum of PbO or pyrochlore peak intensity. As shown, piezoelectric material layer 602 demonstrated a higher ratio of (002)/max (PbO, pyrocholore) intensity, while piezoelectric material layer 604 demonstrated a significantly greater ratio of (002)/(111) intensity.

In summary, thin piezoelectric films having highly uniform thicknesses and crystal orientations may be formed though the methods disclosed herein. In certain examples, the highly-uniform piezoelectric films are facilitated by deposition of ultra-thin TiOx seed layers having uniform thicknesses from center to edge. In certain examples, the highly-uniform piezoelectric films are facilitated by deposition of PZT template layers closely matching the crystal structures of subsequently formed piezoelectric films. The increased uniformity of the piezoelectric films results excellent piezoelectric properties, thus enabling improved piezoelectric performance of the resulting devices.

While the foregoing is directed to embodiments of the present disclosure, other and further embodiments of the disclosure may be devised without departing from the scope thereof, and the scope thereof is determined by the claims that follow.

## Claims

1. **A piezoelectric** device stack (301), comprising:
a substrate (201) comprising a thermal oxide layer (302);
a first seed layer (304) formed over the thermal oxide layer (302), the first seed layer comprising titanium, Ti;
a bottom electrode layer (306) formed over the first seed layer (304);
a second seed layer (308), the second seed layer (308) having a thickness between 0.5 nm and 5 nm, wherein the second seed layer (308) comprises titanium dioxide having an orientation of <001>;
a template layer (310) formed over the second seed layer (308); and
a piezoelectric material layer (312, 604) formed over the template layer (310), the piezoelectric material layer (312, 604) comprising a piezoelectric material.

2. The piezoelectric device stack of claim 1, wherein the piezoelectric material is a relaxor-lead titanate, PT, type material.

3. The piezoelectric device stack of claim 2, wherein the relaxor-PT type material comprises lead magnesium niobate-PT, PMN-PT, or lead indium niobate-lead magnesium niobate-PT, PIN-PMN-PT.

4. The piezoelectric device stack of claim 3, the template layer (310) having a crystal structure substantially the same as a crystal structure of the piezoelectric material layer (312, 604).

5. The piezoelectric device stack of claim 4, wherein the template layer (310) comprises perovskite lead zirconate titanate, PZT,.

6. The piezoelectric device stack of claim 4, wherein the template layer (310) has a thickness between 10 nm and 200 nm; or
wherein the template layer (310) and the piezoelectric material layer (312, 604) have an orientation of <001>.

7. The piezoelectric device stack of claim 1, wherein the first seed layer (304) comprises titanium dioxide.

8. The piezoelectric device stack of claim 1, wherein the bottom electrode layer (306) is formed of platinum, Pt, having an orientation of <111>.

9. The piezoelectric device stack of claim 2 or 3, wherein the template layer (310) is a perovskite lead zirconate titanate, PZT, template layer (310) disposed on the second seed layer (308);
wherein:
the first seed layer (304) is a titanium oxide, TiOx, seed layer disposed on the thermal oxide layer (302);
the bottom electrode layer (306) is a platinum electrode layer and is disposed on the first seed layer (304);
the second seed layer (308) is disposed on the bottom electrode layer (306), and
the piezoelectric material layer (312, 604) is disposed on the PZT template layer (310).

10. A method (400) of forming a piezoelectric device stack (301), comprising:
(408) forming a seed layer (308) over a substrate (201), comprising:
depositing a titanium, Ti, film over the substrate (201) via physical vapor deposition, PVD; and
exposing the titanium film to an anneal process to form titanium dioxide, TiO₂, the seed layer having a thickness between 0.5 nm and 5 nm, the titanium dioxide having an orientation of <001>;
(410) forming a template layer (310) over the seed layer (308); and
(412) forming a piezoelectric material layer (312, 604) over the template layer (310), wherein piezoelectric material of the piezoelectric material layer (312, 604) is deposited via PVD.

11. The method (400) of claim 10, wherein the seed layer (308) has a thickness of 2 nm.

12. The method (400) of claim 10, wherein the template layer (310) has a crystal structure substantially the same as a crystal structure of the piezoelectric material layer (312, 604), particularly
wherein the template layer (310) comprises perovskite lead zirconate titanate, PZT.

13. The method (400) of claim 10, wherein the piezoelectric material is a relaxor-lead titanate, PT, type material, particularly
wherein the relaxor-PT type material comprises lead magnesium niobate-PT, PMN-PT, or lead indium niobate-lead magnesium niobate-PT, PIN-PMN-PT.

## Patentansprüche

1. Piezoelektrischer Vorrichtungsstapel (301), umfassend:
ein Substrat (201), umfassend eine thermische Oxidschicht (302);
eine erste Keimschicht (304), ausgebildet über der thermischen Oxidschicht (302), wobei die erste Keimschicht Titan, Ti, umfasst;
eine untere Elektrodenschicht (306), ausgebildet über der ersten Keimschicht (304);
eine zweite Keimschicht (308), wobei die zweite Keimschicht (308) eine Dicke zwischen 0,5 nm und 5 nm aufweist, wobei die zweite Keimschicht (308) Titandioxid mit einer Orientierung von <001> umfasst;
eine Templatschicht (310), ausgebildet über der zweiten Keimschicht (308); und
eine piezoelektrische Materialschicht (312, 604), ausgebildet über der Templatschicht (310), wobei die piezoelektrische Materialschicht (312, 604) ein piezoelektrisches Material umfasst.

2. Piezoelektrische Vorrichtungsstapel nach Anspruch 1, wobei das piezoelektrische Material ein Material vom Relaxor-Bleititanat-Typ, PT, ist.

3. Piezoelektrischer Vorrichtungsstapel nach Anspruch 2, wobei das Material vom Relaxor-PT-Typ Bleimagnesiumniobat-PT, PMN-PT, oder Bleiindiumniobat-Bleimagnesiumniobat-PT, PIN-PMN-PT, umfasst.

4. Piezoelektrischer Vorrichtungsstapel nach Anspruch 3, wobei die Templatschicht (310) eine Kristallstruktur aufweist, die im Wesentlichen die gleiche ist wie eine Kristallstruktur der piezoelektrischen Materialschicht (312, 604).

5. Piezoelektrischer Vorrichtungsstapel nach Anspruch 4, wobei die Templatschicht (310) Perowskit-Bleizirkonattitanat, PZT, umfasst.

6. Piezoelektrischer Vorrichtungsstapel nach Anspruch 4, wobei die Templatschicht (310) eine Dicke zwischen 10 nm und 200 nm aufweist; oder
wobei die Templatschicht (310) und die piezoelektrische Materialschicht (312, 604) eine Orientierung von <001> aufweisen.

7. Piezoelektrischer Vorrichtungsstapel nach Anspruch 1, wobei die erste Keimschicht (304) Titandioxid umfasst.

8. Piezoelektrischer Vorrichtungsstapel nach Anspruch 1, wobei die untere Elektrodenschicht (306) aus Platin, Pt, mit einer Orientierung von <111> gebildet ist.

9. Piezoelektrischer Vorrichtungsstapel nach Anspruch 2 oder 3, wobei die Templatschicht (310) eine Perowskit-Bleizirkonattitanat-, PZT-, Templatschicht (310) ist, die auf der zweiten Keimschicht (308) angeordnet ist; wobei:
die erste Keimschicht (304) eine Titanoxid-, TiOx-, Keimschicht ist, die auf der thermischen Oxidschicht (302) angeordnet ist;
die untere Elektrodenschicht (306) eine Platinelektrodenschicht ist und auf der ersten Keimschicht (304) angeordnet ist;
die zweite Keimschicht (308) auf der unteren Elektrodenschicht (306) angeordnet ist,
und
die piezoelektrische Materialschicht (312, 604) auf der PZT-Templatschicht (310) angeordnet ist.

10. Verfahren (400) zum Ausbilden eines piezoelektrischen Vorrichtungsstapels (301), umfassend:
(408) Ausbilden einer Keimschicht (308) über einem Substrat (201), umfassend:
Abscheiden eines Titan-, Ti-, Films über dem Substrat (201) mittels physikalischer Gasphasenabscheidung, PVD; und
Aussetzen des Titanfilms einem Glühprozess, um Titandioxid, TiO2, zu bilden, wobei die Keimschicht eine Dicke zwischen 0,5 nm und 5 nm aufweist, wobei das Titandioxid eine Orientierung von <001> aufweist;
(410) Ausbilden einer Templatschicht (310) über der Keimschicht (308); und
(412) Ausbilden einer piezoelektrischen Materialschicht (312, 604) über der Templatschicht (310), wobei piezoelektrisches Material der piezoelektrischen Materialschicht (312, 604) mittels PVD abgeschieden wird.

11. Verfahren (400) nach Anspruch 10, wobei die Keimschicht (308) eine Dicke von 2 nm aufweist.

12. Verfahren (400) nach Anspruch 10, wobei die Templatschicht (310) eine Kristallstruktur aufweist, die im Wesentlichen die gleiche ist wie eine Kristallstruktur der piezoelektrischen Materialschicht (312, 604), insbesondere
wobei die Templatschicht (310) Perowskit-Bleizirkonattitanat, PZT, umfasst.

13. Verfahren (400) nach Anspruch 10, wobei das piezoelektrische Material ein Material vom Relaxor-Bleititanat-Typ, PT, ist, insbesondere
wobei das Material vom Relaxor-PT-Typ Bleimagnesiumniobat-PT, PMN-PT, oder Bleiindiumniobat-Bleimagnesiumniobat-PT, PIN-PMN-PT, umfasst.

## Revendications

1. Empilement de dispositifs piézoélectriques (310), comprenant :
un substrat (201) comprenant une couche d'oxyde thermique (302) ;
une première couche de germe (304) formée sur la couche d'oxyde thermique (302), la première couche de germe comprenant du titane, Ti ;
une couche d'électrode inférieure (306) formée sur la première couche de germe (304) ;
une seconde couche de germe (308), la seconde couche de germe (308) ayant une épaisseur comprise entre 0,5 nm et 5 nm, dans lequel la seconde couche de germe (308) comprend du dioxyde de titane ayant une orientation de <001> ;
une couche de gabarit (310) formée sur la seconde couche de germe (308) ; et
une couche de matériau piézoélectrique (312, 604) formée sur la couche de gabarit (310), la couche de matériau piézoélectrique (312, 604) comprenant un matériau piézoélectrique.

2. Empilement de dispositifs piézoélectriques selon la revendication 1, dans lequel le matériau piézoélectrique est un matériau de type titanate de plomb, PT, -relaxeur.

3. Empilement de dispositifs piézoélectriques selon la revendication 2, dans lequel le matériau de type PT-relaxeur comprend du niobate de plomb magnésium-PT, PMN-PT, ou du niobate de plomb indium-niobate de plomb magnésium-PT, PIN-PMN-PT.

4. Empilement de dispositifs piézoélectriques selon la revendication 3, dans lequel la couche de gabarit (310) a une structure cristalline sensiblement identique à une structure cristalline de la couche de matériau piézoélectrique (312, 604).

5. Empilement de dispositifs piézoélectriques selon la revendication 4, dans lequel la couche de gabarit (310) comprend du titanate de zirconate de plomb pérovskite, PZT.

6. Empilement de dispositifs piézoélectriques selon la revendication 4, dans lequel la couche de gabarit (310) a une épaisseur comprise entre 10 nm et 200 nm ; ou
dans lequel la couche de gabarit (310) et la couche de matériau piézoélectrique (312, 604) ont une orientation de <001>.

7. Empilement de dispositifs piézoélectriques selon la revendication 1, dans lequel la première couche de germe (304) comprend du dioxyde de titane.

8. Empilement de dispositifs piézoélectriques selon la revendication 1, dans lequel la couche d'électrode inférieure (306) est formée en platine, Pt, ayant une orientation de <111>.

9. Empilement de dispositifs piézoélectriques selon la revendication 2 ou la revendication 3, dans lequel la couche de gabarit (310) est une couche de gabarit en titanate de zirconate de plomb pérovskite, PZT, (310) disposée sur la seconde couche de germe (308) ;
dans lequel :
la première couche de germe (304) est une couche de germe d'oxyde de titane, TiOx, disposée sur la couche d'oxyde thermique (302) ;
la couche d'électrode inférieure (306) est une couche d'électrode en platine et est disposée sur la première couche de germe (304) ;
la seconde couche de germe (308) est disposée sur la couche d'électrode inférieure (306), et
la couche de matériau piézoélectrique (312, 604) est disposée sur la couche de gabarit en PZT (301).

10. Procédé (400) de formation d'un empilement de dispositifs piézoélectriques (301), comprenant :
une étape de formation (408) d'une couche de germe (308) sur un substrat (201), consistant à :
déposer un film de titane, Ti, sur le substrat (201) par le biais d'un dépôt chimique en phase vapeur, dit PVD ; et
exposer le film de titane à un traitement de recuit pour former du dioxyde de titane, TiO₂, la couche de germe ayant une épaisseur comprise entre 0,5 nm et 5 nm, le dioxyde de titane ayant une orientation de <001> ;
une étape de formation (410) d'une couche de gabarit (310) sur la couche de germe (308) ; et
une étape de formation (412) d'une couche de matériau piézoélectrique (312, 604) sur la couche de gabarit (310), dans lequel le matériau piézoélectrique de la couche de matériau piézoélectrique (312, 604) est déposé par le biais d'un PVD.

11. Procédé (400) selon la revendication 10, dans lequel la couche de germe (308) a une épaisseur de 2 nm.

12. Procédé (400) selon la revendication 10, dans lequel la couche de gabarit (310) a une structure cristalline sensiblement identique à une structure cristalline de la couche de matériau piézoélectrique (312, 604), particulièrement dans lequel la couche de gabarit (310) comprend du titanate de zirconate de plomb pérovskite, PZT.

13. Procédé (400) selon la revendication 10, dans lequel le matériau piézoélectrique est un matériau de type titanate de plomb, PT, -relaxeur, particulièrement dans lequel le matériau de type PT-relaxeur comprend du niobate de plomb magnésium-PT, PMN-PT, ou du niobate de plomb indium-niobate de plomb magnésium-PT, PIN-PMN-PT.
